# EUROPÄISCHE PATENTSCHRIFT

(11) **EP 2 618 029 B1**
(45) Veröffentlichungstag und Bekanntmachung des Hinweises auf die Patenterteilung: **08.04.2015**
(21) Anmeldenummer: 12151603.3
(22) Anmeldetag: 18.01.2012
(51) Int. Cl.: F16H 55/06

(54) **Beschichtetes Zahnrad**
Coated cogwheel
Roue dentée revêtue

(43) Veröffentlichungstag der Anmeldung: 24.07.2013
(73) Patentinhaber: Siemens Aktiengesellschaft, 80333 München (DE)
(72) Erfinder: Meis, Jean-Andre, 48249 Duelmen (DE)

(56) Entgegenhaltungen:
- DE-A1- 4 315 355
- DE-A1-102008 032 656
- JP-A- 2 008 542
- US-A- 4 944 196

## Beschreibung

Die vorliegende Erfindung betrifft ein beschichtetes Zahnrad und ein Verfahren zur Herstellung eines beschichteten Zahnrads.

Einsatzhärten ist ein verbreitetes Verfahren zum Härten von Antriebsteilen und Zahnrädern, das z.B. in DE 569 453 A und DE 2 109 494 B beschrieben ist. Dadurch ergeben sich eine hohe Randhärte und Druckspannungen, welche dem Verschleiß und den Versagensformen, die durch Hertzsche Pressung hervorgerufen werden, entgegenwirken.

Darüber hinaus ist es bekannt, dass spezielle Beschichtungen von druckbelasteten Bereichen von Zahnrädern den Verschleiß weiter verringern können. DE 197 24 661 C2 beschreibt eine Beschichtung eines verzahnten Getriebeteils mit Kohlenstoff in einer diamantähnlichen Struktur sowie eine keramische TiN-Beschichtung.

DE 10 2008 032 656 A1 beschreibt, welches als der nächste Stand der Technik angesehen wird, ein Verfahren zur Beschichtung eines Zahnrads mit folgenden Schritten: Bereitstellen eines Zahnrads, Aufbringen einer reibungsmindernden, verschleißarmen Beschichtung auf die Zahnflanken der Zähne des Zahnrads, wobei vor dem Aufbringen der Beschichtung zwischen den einzelnen Zähnen des Zahnrads befindliche Zahngrundbereiche maskiert werden, so dass die maskierten Zahngrundbereiche unbeschichtet bleiben.

JP 2 008542 A beschreibt ein Kunststoff-Zahnrad, dessen Zahnflanken vollflächig mit einer Nylon-Graphit-Schicht beschichtet sind, um den Verschleiß zu verringern.

DE 4315355 A1 beschreibt ein Antriebsrad oder eine Antriebsradgrundscheibe mit Antriebsradsegmenten für den Antrieb von Gleiskatten, Förderketten und ähnlichen Antriebssystemen. Gemäß Fig. 12 kann ein mehrteiliger Zahnmuldeneinsatz vorgesehen sein, in Form von Streifen, die quer zum Antriebsrad angeordnet sind.

Allerdings kann es bei beschichteten Zahnrädern im Falle einer ungleichmäßigen Belastung zu einem Abplatzen einer solchen Beschichtung kommen, wodurch die Lebensdauer der Zahnräder stark begrenzt wird.

Aufgabe der vorliegenden Erfindung ist es, ein beschichtetes Zahnrad bereitzustellen, das diesen Nachteil nicht aufweist.

Die Aufgabe wird gelöst durch ein beschichtetes Zahnrad gemäß Anspruch 1. Die Aufgabe wird ferner gelöst durch ein Verfahren zum Herstellen eines beschichteten Zahnrads gemäß Anspruch 5.

In realen Anwendungen ist eine Belastung fast nie gleichmäßig über einen belasteten Bereich eines Zahnrads, insbesondere eine Zahnflanke, verteilt, z.B. bedingt durch eine Schiefstellung von Wellen oder eine Nachgiebigkeit eines Gehäuses. Diese Inhomogenitäten können auch nicht immer durch Korrekturen unterdrückt werden, da Korrekturen immer nur für eine bestimmte Last optimal sind. Der belastete Bereich, z.B. die Zahnflanke, muss sich daher zusätzlich entweder über eine elastische Verformung oder durch Einlaufverschleiß an die ungleichmäßige Belastung anpassen und diese vergleichmäßigen. Da beide Mechanismen bei einer herkömmlich praktizierten Ausführung von Verschleißschutzschichten als vollständig geschlossene Schichten erschwert sind, kam es bisher häufig zu einem Abplatzen der Verschleißschutzschichten. Dieser Nachteil wird durch die erfindungsgemäße Segmentierung der Verschleißschutzschicht vermieden.

Der Erfindung liegt die Erkenntnis zugrunde, dass durch eine Segmentierung einer relativ harten Schicht, die bei einem Zahnrad als Verschleißschutz auf einem Zahnradkörper aus einem weicheren Grundwerkstoff aufgebracht ist, eine Verteilung der beiden vorteilhaften Eigenschaften Festigkeit und Flexibilität auf verschiedene Oberflächenniveaus des Zahnrads möglich ist. Im Folgenden werden die Begriffe "Schicht", "Beschichtung" und "Verschleißschutzschicht" gleichbedeutend verwendet.

Die segmentierte Schicht bietet durch ihre Härte einen Verschleißschutz, während die Fugen zwischen den Segmenten es den einzelnen Segmenten ermöglichen, sich unter Last individuell auszurichten. Eine ungleichmäßige Belastung des beschichteten Zahnrads kann auf diese Weise besser ausgeglichen werden als ohne Segmentierung, so dass ein Abplatzen der Beschichtung vermieden wird. Insgesamt ergibt sich ein in Bezug auf eine Belastung des Zahnrads verbessertes Eigenschaftsprofil, da zum Einen durch die harte Oberflächenschicht ein Verschleißschutz und zum Anderen durch die Unterteilung der Schicht in separate Segmente eine Flexibilität und Nachgiebigkeit gegeben ist. Das Zahnrad kann in seinen beschichteten Bereichen somit zwei sonst eher als konträr betrachtete Eigenschaften vereinen.

Im Vergleich zu durchgehenden, d.h. geschlossenen Beschichtungen, die sich unter Last häufig als unflexibel erweisen, ist durch die vorliegende Erfindung bzw. vorteilhafte Ausgestaltungen eine gleichmäßigere Lastverteilung über eine Zahnradoberfläche, insbesondere eine Zahnflankenoberfläche, möglich. Dies verbessert den Schutz gegenüber Verschleiß.

Vorteilhafte Ausgestaltungen und Weiterbildungen der Erfindung ergeben sich aus den abhängigen Ansprüchen. Dabei kann das erfindungsgemäße Verfahren auch entsprechend den abhängigen Vorrichtungsansprüchen weitergebildet sein, und umgekehrt.

Gemäß der Erfindung bildet die Schicht eine Oberfläche des beschichteten Zahnrads. Die als Verschleißschutz dienende Schicht, die härter und üblicherweise auch unflexibler als der Grundwerkstoff ist, aus dem der Zahnradkörper gefertigt ist, ist also als eine äußere Oberfläche des Zahnrads ausgebildet. Dadurch kann die Schicht optimal als Verschleißschutzschicht fungieren.

Gemäß der Erfindung ist die Schicht auf Zahnflanken des Zahnradkörpers angeordnet. Eine Zahnflanke ist in der Regel der Bereich eines Zahnrads, welcher in besonderem Maße einer Belastung und somit einem Verschleiß unterliegt. Dabei ist die segmentierte Schicht ausschließlich auf den Zahnflanken des Zahnradkörpers angeordnet. Auf diese Weise wird z.B. die nötige Elastizität im Bereich des Zahngrunds nicht beeinträchtigt.

Zur Erhöhung der Tragfähigkeit von Verzahnungen werden diese mit einer Beschichtung versehen, die nicht durchgehend bzw. geschlossen ausgeführt ist, sondern segmentiert ist. Zwischen aneinander grenzenden Segmenten sind Fugen gebildet, die keine Beschichtung aufweisen. Gemäß einer bevorzugten Ausgestaltung der Erfindung ist die Schicht durch die Fugen vollständig durchtrennt. Auf diese Weise sind die einzelnen Segmente der Schicht voneinander völlig getrennt, und somit fähig, sich voneinander völlig unabhängig auszurichten. Dadurch werden Spannungen in der Beschichtung weitgehend vermieden und somit ein Abplatzen der Schicht verhindert.

Gemäß einer bevorzugten Ausgestaltung der Erfindung erstrecken sich die Fugen bis in den Zahnradkörper hinein. Das bedeutet, dass vorzugsweise auch der Grundwerkstoff, auf den die Beschichtung aufgetragen wird, im Bereich der Fugen eingeschnitten wird. Auf diese Weise entsteht eine Zahnradoberfläche, z.B. eine Zahnflanke, die mehrere Plateaus unterschiedlicher Härte aufweist.

Der Effekt der Segmentierung lässt sich also dadurch verstärken, dass nicht nur die Schicht, sondern auch der Grundwerkstoff in einem oberflächennahen Bereich "angeschnitten" wird. So ergibt sich ein Belastungsbereich des Zahnrads, z.B. eine Zahnflanke, welcher aus Plateaus unterschiedlicher Härte und vorzugsweise auch unterschiedlicher Elastizität besteht. Der obere Bereich der Plateaus ist durch die harte Schicht verstärkt, und die Plateaus sind voneinander durch Fugen bzw. Furchen getrennt sind. Die Tiefe der Fugen ist so zu wählen, dass die Plateaus sich flexibel entsprechend der Lastsituation an einer Gegenflanke ausrichten können. Durch ein Anschneiden des Grundwerkstoffs verstärkt sich die vorteilhafte Kombination der Eigenschaften Festigkeit und Flexibilität, da die Fugen Raum für die bei Druckbeanspruchung auftretende Querdehnung geben, und somit die Nachgiebigkeit der Verschleißschutzschicht reduziert ist.

Gemäß einer bevorzugten Ausgestaltung der Erfindung sind die Fugen so breit, dass sie Raum für eine bei einer Druckbelastung des beschichteten Zahnrads auftretende Querdehnung lassen. Durch eine ausreichende Breite der Fugen verstärkt sich die vorteilhafte Kombination der Eigenschaften Festigkeit und Flexibilität, da die Fugen Raum für die bei Druckbeanspruchung auftretende Querdehnung geben, und somit die Nachgiebigkeit der Verschleißschutzschicht reduziert ist. Die Form der beschichteten und die Größe der unbeschichteten Bereiche sind dabei an die weiteren Randbedingungen hin anzupassen. Grundsätzlich ist jede Form möglich. Auch der Schichttyp ist frei wählbar, da sich das Verfahren grundsätzlich für alle Schichttypen eignet.

Die Segmente können durch Einschneiden einer ursprünglich geschlossenen Beschichtung oder durch Abdecken der späteren Fugen mit einer Maske, anschließendem Auftragen der Beschichtung und abschließenden Entfernen der Maske gebildet werden.

Gemäß einer bevorzugten Weiterbildung der Erfindung umfasst das Anordnen der Schicht folgende Schritte: Abdecken der Fugenbereiche mit einer Abdeckung; Aufbringen der Schicht auf nicht abgedeckte Bereiche des Zahnradkörpers; und Entfernen der Abdeckung. Hierbei wird die Schicht direkt segmentiert aufgebracht, indem z.B. die Zwischenbereiche mit einer Struktur abgedeckt werden, so dass dort der Grundwerkstoff unbeschichtet bleibt.

Es ist möglich, dass das Anordnen der Schicht folgende Schritte umfasst: Aufbringen einer geschlossenen Schicht auf den Zahnradkörper; und Segmentieren der geschlossenen Schicht durch ein Ausbilden der Fugen. Hierbei wird die Schicht zunächst geschlossen aufgetragen und anschließend in die einzelnen Segmente zerteilt.

Gemäß einer bevorzugten Ausgestaltung der Erfindung erfolgt das Ausbilden der Fugen mittels eines Laserstrahls. Es sind aber auch andere Verfahren, z.B. mechanisches, chemisches oder elektrisches Abtragen, möglich.

Die oben beschriebenen Eigenschaften, Merkmale und Vorteile dieser Erfindung sowie die Art und Weise, wie diese erreicht werden, werden klarer und deutlicher verständlich durch die folgende Beschreibung der Ausführungsbeispiele, welche anhand der Zeichnungen näher erläutert werden. Es zeigt jeweils schematisch und nicht maßstabsgetreu
- Fig. 1: einen Zahnradkörper;
- Fig. 2: eine beschichtete Zahnflanke;
- Fig. 3: eine segmentierte Schicht;
- Fig. 4-6: ein erstes Ausführungsbeispiel des Herstellungsverfahrens;
- Fig. 7-8: ein weiteres Ausführungsbeispiel des Herstellungsverfahrens; und
- Fig. 9: einen Schnitt durch eine beschichtete Zahnflanke mit bis in den Zahnradkörper reichenden Fugen.

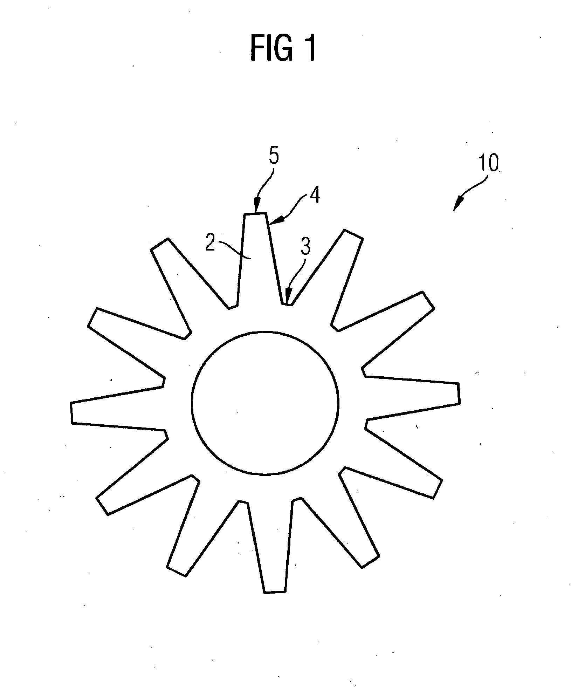

Fig. 1 zeigt eine Ansicht eines zu beschichtenden Zahnradkörper 10, der aus einem Grundwerkstoff, z.B. aus gehärtetem Stahl wie 16MnCr5 oder 18CrNiMo7-6, gefertigt ist. Entlang dem äußeren Umfang des Zahnradkörpers 10 sind Zähne 2 angeordnet, welche jeweils einen Zahngrund 3, eine Zahnflanke 4 und einen Zahnkopf 5 aufweisen.

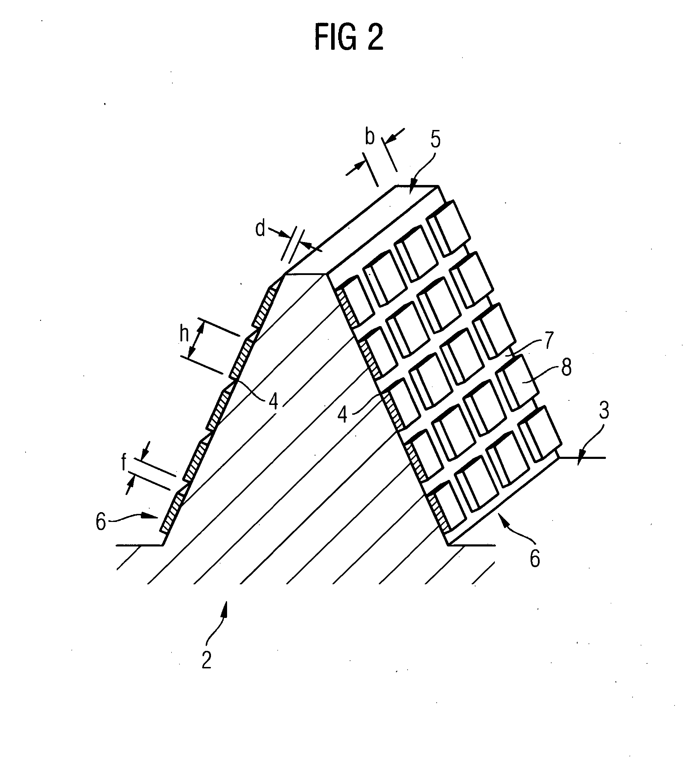

Fig. 2 zeigt eine perspektivische Ansicht eines Zahns 2 des in Fig. 1 dargestellten Zahnradkörpers 10. Auf beiden Flanken 4 des Zahns 2 ist eine Schicht 6 angeordnet, welche härter als der Grundwerkstoff des Zahnradkörpers 10 ist und dadurch den Verschleiß der Zahnflanken 4 vermindert. Die Schicht 6 der Dicke d ist nicht geschlossen über die Zahnflanke 4 ausgebildet, sondern in eine Vielzahl von Segmenten 8 unterteilt. Zwei benachbarte Segmente 8 sind durch eine Fuge 7 mit einer Fugenbreite f voneinander getrennt. Die Segmente 8 weisen jeweils eine Breite b und eine Höhe h auf. Der Zahngrund 3 und der Zahnkopf 5 sind von der Beschichtung 6 freigehalten, um in diesen Bereichen die Elastizität nicht einzuschränken.

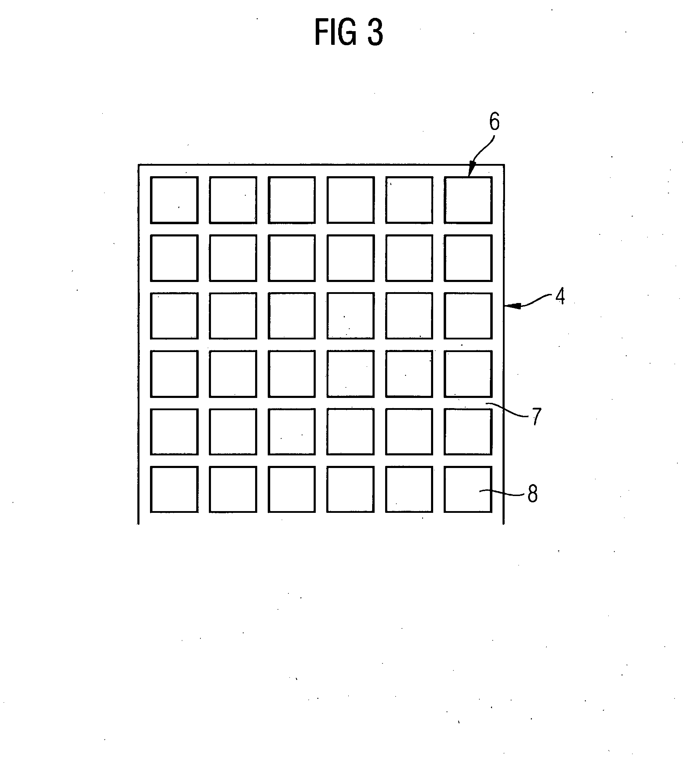

Fig. 3 zeigt eine Frontalansicht der in Fig. 2 dargestellten Zahnflanke 4. Die auf der Zahnflanke 4 angeordnete Schicht 6 ist nicht durchgehend ausgeführt, sondern segmentiert. Zwischen aneinander grenzenden Segmenten 8 sind Fugen 7 gebildet, die keine Beschichtung aufweisen.

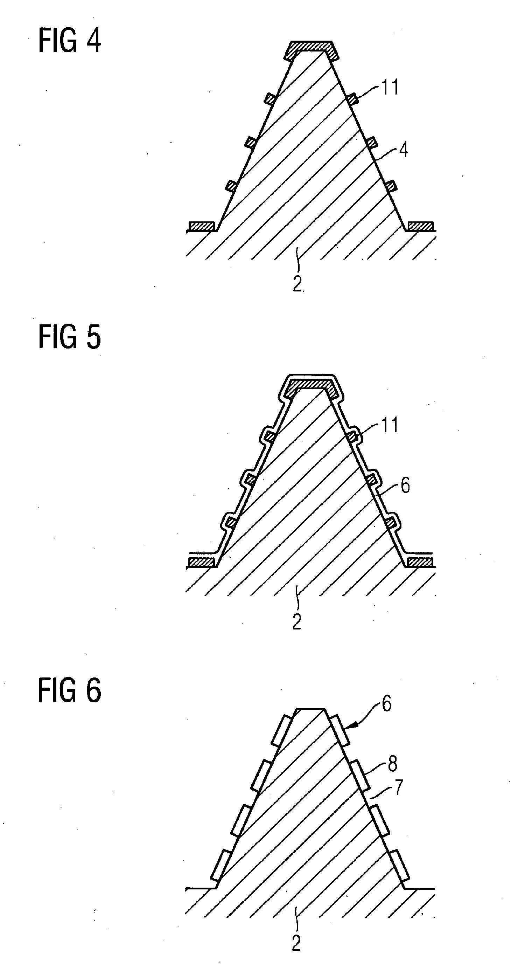

Die Fig. 4 bis 6 zeigen ein erstes Ausführungsbeispiel des Herstellungsverfahrens.

Fig. 4 zeigt einen Schnitt eines Zahns 2 eines Zahnradkörpers. In einem ersten Verfahrensschritt wird auf den Zahnflanken 4 in Bereichen, in denen Fugen 7 vorgesehen sind, eine Abdeckung 11 aufgebracht. Dieses Maskieren kann z.B. durch Aufbringen einer vorzugsweise wasser- bzw. lösemittellöslichen Lackschicht 11 oder durch Abdecken der Fugenbereiche 7 mittels Abdeckelementen (nicht dargestellt) erfolgen.

In einem weiteren, in Fig. 5 dargestellten Schritt werden die Zahnflanken 4 mit einem reibungs- und verschleißmindernden Beschichtungsmaterial, wie z.B. Diamond-Like Carbon (= DLC) oder TiN, beschichtet, um eine Verschleißschutzschicht auszubilden. Dabei kann das Beschichtungsmaterial ganzflächig auf die Zahnflanke 4 aufgetragen werden, d.h. sowohl in den abgedeckten Bereichen 11 als auch in den unbedeckten Bereichen. Die Dicke der Verschleißschutzschicht in den Abschnitten zwischen den abdeckten Bereichen 11 ist in der Praxis natürlich wesentlich geringer als dies in Fig. 5 dargestellt ist.

In einem dritten Schritt, der in Fig. 6 dargestellt ist, wird die Maskierung 11 der Zahnflanken 4 wieder entfernt. Durch das Entfernen der Maskenschicht 11 wird auch Beschichtungsmaterial, das auf die Abdeckung 11 aufgetragen wurde, mit entfernt. Im Endergebnis liegt die Schicht 6 in Form einer Vielzahl voneinander getrennter Segmente 8 vor. Das Entfernen einer als Lackschicht ausgebildeten Maskenschicht 11 kann durch ein chemisches Abätzen, durch Abwaschen und mechanisch erfolgen, z.B. mithilfe eines Wasserstrahls oder durch Bürsten.

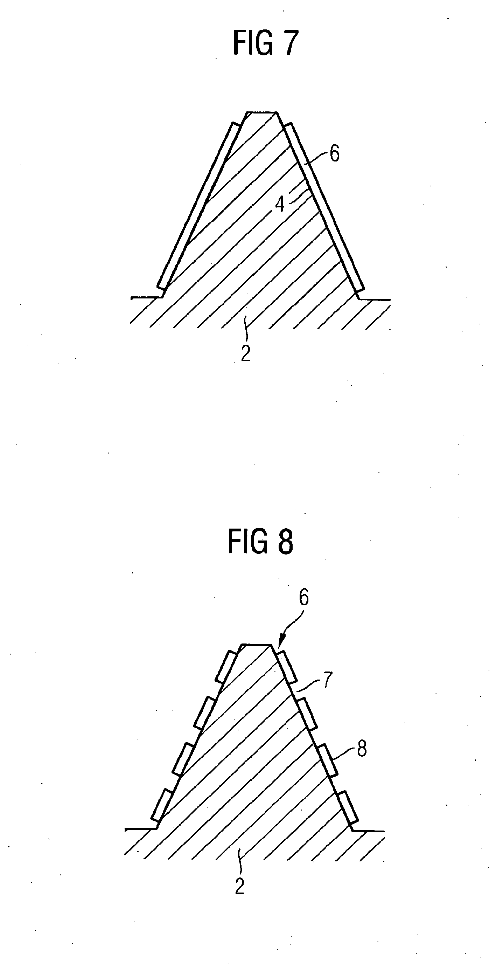

Die Fig. 7 und 8 zeigen ein weiteres Ausführungsbeispiel des Herstellungsverfahrens.

Fig. 7 zeigt einen Schnitt eines Zahns 2 eines Zahnradkörpers. In einem ersten Verfahrensschritt werden die Zahnflanken 4 mit einem reibungs- und verschleißmindernden Beschichtungsmaterial, wie z.B. Diamond-Like Carbon (= DLC) oder TiN, als durchgehend bzw. geschlossen ausgeführte Schicht 6 beschichtet, um eine Verschleißschutzschicht auszubilden.

In einem weiteren, in Fig. 8 dargestellten Schritt werden in der durchgehenden, d.h. unterbrechungsfreien bzw. geschlossenen, Schicht 6 Fugen 7 gebildet, wodurch die durchgehende Schicht 6 in Segmente 8 unterteilt wird. Die Ausbildung der Fugen 7 kann mittels eines Laserstrahls oder einer mechanischen Abtragung, z.B. mit einem Stichel, erfolgen. Es ist auch möglich, dass die Fugen durch ein bekanntes chemisches Maskierungsverfahren ausgebildet werden.

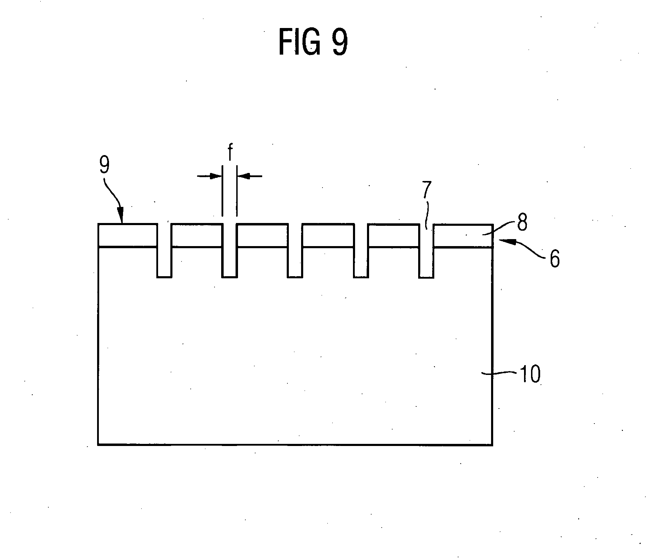

Fig. 9 zeigt einen Schnitt durch eine aus einem Grundwerkstoff gefertigten Zahnradkörper 10, dessen Oberfläche 9 durch eine auf dem Zahnradkörper 10 aufgebrachte Schicht 6 gebildet ist. Die Schicht 6 ist durch bis in den Zahnradkörper 10 reichende Fugen 7 in separate Segmente 8 unterteilt. Die Schicht 6 ist also so gestaltet, dass sie aus vielen einzelnen Schichtbereichen 8 besteht, die wie Fliesen mit einem Abstand f zueinander auf dem Grundwerkstoff liegen, z.B. auf einer Zahnflanke.

Obwohl die Erfindung im Detail durch die bevorzugten Ausführungsbeispiele näher illustriert und beschrieben wurde, ist die Erfindung nicht durch die offenbarten Beispiele eingeschränkt, und andere Variationen können vom Fachmann hieraus abgeleitet werden, ohne den Schutzumfang der Erfindung zu verlassen.

## Patentansprüche

1. Beschichtetes Zahnrad (1), umfassend einen aus einem Grundwerkstoff gefertigten Zahnradkörper (10), wobei auf den Zahnflanken (4) des Zahnradkörpers (10) eine Schicht (6) angeordnet ist, welche härter als der Grundwerkstoff und durch Fugen (7) in eine Vielzahl voneinander getrennter Segmente (8) unterteilt ist,
**dadurch gekennzeichnet, dass** der Zahngrund (3) und der Zahnkopf (5) von der Beschichtung freigehalten sind, und die Segmente (8) bei Frontalansicht der Zahnflanke (4) einen einheitlichen quadratischen Grundriss aufweisen und schachbrettförmig in in axialer Richtung des Zahnrads (1) verlaufenden Reihen und quer dazu verlaufenden Spalten angeordnet sind.

2. Beschichtetes Zahnrad (1) nach Anspruch 1, **dadurch gekennzeichnet, dass** die Fugen (7) die Schicht (6) vollständig durchtrennen.

3. Beschichtetes Zahnrad (1) nach einem der vorhergehenden Ansprüche,
**dadurch gekennzeichnet, dass** sich die Fugen (7) bis in den Zahnradkörper (10) hinein erstrecken.

4. Beschichtetes Zahnrad (1) nach einem der vorhergehenden Ansprüche,
**dadurch gekennzeichnet, dass** die Fugen (7) so breit sind, dass sie Raum für eine bei einer Druckbelastung des beschichteten Zahnrads (1) auftretende Querdehnung lassen.

5. Verfahren zum Herstellen eines beschichteten Zahnrads (1), mit folgenden Schritten:
Bereitstellen eines aus einem Grundwerkstoff gefertigten Zahnradkörpers (10); und
Anordnen einer Schicht (6) auf den Zahnflanke (4) des Zahnradkörpers (10), wobei die Schicht (6) härter als der Grundwerkstoff und in eine Vielzahl durch Fugen (7) voneinander getrennter Segmente (8) unterteilt ist, **dadurch gekennzeichnet, dass** der Zahngrund(3) und der Zahnkopf (5) von der Beschichtung freigehalten sind, und die Segmente (8) bei Frontalansicht der Zahnflanke (4) einen einheitlichen quadratischen Grundriss aufweisen und schachbrettförmig in in axialer Richtung des Zahnrads (1) verlaufenden Reihen und quer dazu verlaufenden Spalten angeordnet sind.

6. Verfahren nach Anspruch 5,
**dadurch gekennzeichnet, dass** das Anordnen der Schicht (6) folgende Schritte umfasst:
Abdecken der Fugenbereiche (7) mit einer Abdeckung (11);
Aufbringen der Schicht (6) auf nicht abgedeckte Bereiche des Zahnradkörpers (10); und
Entfernen der Abdeckung (11).

7. Verfahren nach Anspruch 5,
**dadurch gekennzeichnet, dass** das Anordnen der Schicht (6) folgende Schritte umfasst:
Aufbringen einer geschlossenen Schicht (6) auf den Zahnradkörper (10); und
Segmentieren der geschlossenen Schicht (6) durch ein Ausbilden der Fugen (7).

8. Verfahren nach Anspruch 7,
**dadurch gekennzeichnet, dass** das Ausbilden der Fugen (7) mittels eines Laserstrahls erfolgt.

## Claims

1. Coated cogwheel (1) comprising a cogwheel body (10) made from a basis material, with a layer (6) which is harder than the basis material and subdivided by seams (7) into a multiplicity of mutually separated segments (8) being arranged on the tooth flank (4) of the cogwheel body (10), **characterised in that** the tooth base (3) and tooth head (5) have been kept free from coating, and the segments (8) have a uniform square layout when viewed from the front of the tooth flank (4) and are arranged in a chequered pattern in rows running in the axial direction of the cogwheel (1) and transversely running columns.

2. Coated cogwheel (1) according to claim 1,
**characterised in that** the seams (7) completely cut through the layer (6).

3. Coated cogwheel (1) according to one of the preceding claims,
**characterised in that** the seams (7) extend into the cogwheel body (10).

4. Coated cogwheel (1) according to one of the preceding claims,
**characterised in that** the seams (7) are sufficiently wide to leave room for a lateral expansion occurring when the coated cogwheel (1) is subjected to a pressure load.

5. Method for producing a coated cogwheel (1), having the following steps:
Providing a cogwheel body (10) made from a basis material; and
Arranging a layer (6) on the tooth flank (4) of the cogwheel body (10), with the layer (6) being harder than the basis material and subdivided by seams (7) into a multiplicity of mutually separated segments (8), **characterised in that** the tooth base (3) and tooth head (5) have been kept free from coating, and the segments (8) have a uniform square layout when viewed from the front of the tooth flank (4) and are arranged in a chequered pattern in rows running in the axial direction of the cogwheel (1) and transversely running columns.

6. Method according to claim 5,
**characterised in that** arranging the layer (6) comprises the following steps:
Covering the seam regions (7) with a masking means (11);
Applying the layer (6) to non-covered regions of the cogwheel body (10); and
Removing the masking means (11).

7. Method according to claim 5,
**characterised in that** arranging the layer (6) comprises the following steps:
Applying a closed layer (6) to the cogwheel body (10); and
Segmenting the closed layer (6) by forming the seams (7).

8. Method according to claim 7,
**characterised in that** the seams (7) are formed using a laser beam.

## Revendications

1. Roue ( 1 ) dentée revêtue, comprenant un corps ( 10 ) de roue dentée en un matériau de base, une couche ( 6 ), qui est plus dure que le matériau de base et qui est subdivisée par des joints ( 7 ) en une pluralité de segments ( 8 ) séparés les uns des autres, étant mise sur les flancs ( 4 ) de dent du corps ( 10 ) de la roue dentée,
**caractérisée en ce que** le fond ( 3 ) de dent et la tête ( 5 ) de dent sont maintenus sans le revêtement et les segments ( 8 ) ont, en vue frontale du flanc ( 4 ) de la dent, un tracé carré uniforme et sont disposés en échiquier en lignes s'étendant dans la direction axiale de la roue ( 1 ) dentée et en colonnes s'en étendant transversalement.

2. Roue ( 1 ) dentée revêtue suivant la revendication 1, **caractérisée en ce que** les joints ( 7 ) séparent la couche ( 6 ) complètement.

3. Roue ( 1 ) dentée revêtue suivant l'une des revendications précédentes, **caractérisée en ce que** les joints ( 7 ) s'étendent jusqu'à l'intérieur du corps ( 10 ) de la roue dentée.

4. Roue ( 1 ) dentée revêtue suivant l'une des revendications précédentes, **caractérisée en ce que** les joints ( 7 ) sont si larges qu'ils laissent de l'espace pour un allongement transversal se produisant lorsque la roue ( 1 ) dentée revêtue est soumise à une pression.

5. Procédé de fabrication d'une roue ( 1 ) dentée revêtue comprenant les stades dans lesquels :
on se procure un corps ( 10 ) de roue dentée en un matériau de base ; et
on met une couche ( 6 ) sur le flanc ( 4 ) de dent du corps ( 10 ) de roue dentée, la couche ( 6 ) étant plus dure que le matériau de base et étant subdivisée en une pluralité de segments ( 8 ) séparés les uns des autres par des joints ( 7 ), **caractérisé en ce que** le fond ( 3 ) de dent et la tête ( 5 ) de dent sont maintenus exempts du revêtement et les segments ( 8 ) ont, en vue frontale du flanc ( 4 ) de la dent, un tracé carré uniforme et sont disposés en échiquier en lignes s'étendant dans la direction axiale de la roue ( 1 ) dentée et en colonnes s'en étendant transversalement.

6. Procédé suivant la revendication 5,
**caractérisé en ce que** mettre la couche ( 6 ) comprend les stades suivants :
on recouvre les zones ( 7 ) de joint d'un recouvrement ( 11 ) ;
on dépose la couche ( 6 ) sur des régions non recouvertes du corps ( 10 ) de la roue dentée ; et
on élimine le recouvrement ( 11 ).

7. Procédé suivant la revendication 5,
**caractérisé en ce que** mettre la couche ( 6 ) comprend les stades suivants :
on dépose une couche ( 6 ) unie sur le corps ( 10 ) de la roue dentée ; et
on segmente la couche ( 6 ) unie en constituant les joints ( 7 ).

8. Procédé suivant la revendication 7,
**caractérisé en ce que** la constitution des joints ( 7 ) s'effectue au moyen d'un faisceau laser.
